# EUROPEAN PATENT APPLICATION

(11) **EP 4 842 188 A1**
(43) Date of publication of application: **18.11.2026**
(21) Application number: 26176533.3
(22) Date of filing: 05.05.2026
(51) Int. Cl.: H10P 72/78, B25B 11/00, H10P 72/76

(54) **BONDING APPARATUS, HOLDING MEMBER, AND ARTICLE MANUFACTURING METHOD**

(30) Priority: 15.05.2025 JP 2025082124
(71) Applicant: Canon Kabushiki Kaisha, Tokyo 146-8501 (JP)
(72) Inventor: TAKAHASHI, Kai, Tokyo, 146-8501 (JP); MORI, Kenichiro, Tokyo, 146-8501 (JP); KUBOTA, Yusuke, Tokyo, 146-8501 (JP)
(74) Representative: Canon Europe Limited

(57) **Abstract**

A bonding apparatus that bonds a first member and a second member, includes a first holder having a pressure-receiving surface which defines at least a part of a pressure chamber, and a holding surface which holds the first member; a second holder configured to hold the second member; and a shape controller configured to control a shape of the holding surface by controlling a pressure applied to the pressure-receiving surface. An area of the pressure-receiving surface is larger than an area of the first member.

## Description

### TECHNICAL FIELD

The present disclosure relates to a bonding apparatus, a holding member, and an article manufacturing method.

### BACKGROUND

A common example of a method and apparatus for bonding a semiconductor chip is a method in which a solder bump is formed on an electrode and the semiconductor chip is bonded to a substrate by thermocompression bonding. On the other hand, there is a bonding method such as Direct Bonding in which semiconductor chips or wafers are bonded using interatomic bonds due to a Coulomb force or the like, without using an adhesive agent or welding by thermocompression bonding or the like.

In recent years, a chiplet technique has been proposed. The chiplet technique realizes high performance semiconductor elements in one package by bonding different dies with high density I/O. In the chiplet technique, the interval between high density I/O bonding pads arranged on each die is about 1 µm. Therefore, the bonding positional precision of about 100 nm is required. Since the bonding positional precision of a practical bonding apparatus is about 2 µm, improvement of the positional precision is demanded. In this situation, Direct Bonding enables high density/high precision bonding as compared to the conventional bonding methods that use adhesive agents/compression bonding, and is therefore seen as a promising way to improve the bonding precision.

In Direct Bonding, two members are bonded by bringing flat surfaces thereof into contact with each other. Therefore, if there is even a slight unevenness on the flat surface, a gap is generated between the members during bonding, which can lead to a partial void, making it difficult to achieve excellent bonding across the entire bonding surface. Such an unevenness is minute and difficult to visually recognize, and there is a limit to removing the unevenness during processing of semiconductor chips or wafers.

One method for suppressing residual voids generated when bonding members is to form a stress application starting point in the center of the member to be bonded, and expand the bonding from the starting point toward the periphery. According to this method, the voids are expelled as the bonding is expanded, and excellent bonding across the entire bonding surface can be achieved. One method for forming a stress application starting point in the center of the member to be bonded is to deform the holding surface holding a semiconductor chip into a convex shape, thereby deforming the semiconductor chip to follow the shape of the holding surface and starting the contact of the semiconductor chip with a bonding target member from the center of the semiconductor chip. Japanese Patent Laid-Open No. 2021-141194 discloses a member bonding apparatus that changes a support surface supporting a member from a flat surface to a curved surface. Japanese Patent Laid-Open No. 2024-074280 discloses a bonding tool that includes a protrusion configured to be movable between a retracted position within the die holding surface and an extended position protruding from the die holding surface.

### SUMMARY

The present disclosure provides a technique for properly bonding two members.

The present disclosure in its first aspect provides a bonding apparatus as specified in claim 1. Optional features are specified in claim 2 to 16.

The present disclosure in its second aspect provides a holding member as specified in claim 17.

The present disclosure in its third aspect provides an article manufacturing method as specified in claim 18.

Features of the present disclosure will become apparent from the following description of embodiments with reference to the attached drawings. The following description of embodiments is described by way of example.

### BRIEF DESCRIPTION OF THE DRAWINGS

The accompanying drawings, which are incorporated in and constitute a part of the specification, illustrate embodiments of the present disclosure, and together with the description, serve to explain the principles of the embodiments.
Fig. 1A is a view schematically showing a configuration example and operation example of a bonding apparatus according to an embodiment;
Fig. 1B is a view schematically showing the configuration example and operation example of the bonding apparatus according to the embodiment;
Fig. 1C is a view schematically showing the configuration of a holding member applicable to the bonding apparatus according to the embodiment;
Figs. 2A to 2C are views schematically showing the configuration of the holding member or chuck applicable to the bonding apparatus according to the embodiment;
Figs. 3A to 3D are views showing configuration examples of a holding surface;
Figs. 4A to 4C are views for explaining expulsion of voids during bonding;
Figs. 5A and 5B are views illustrating the curvature amount of the holding surface;
Figs. 6A to 6C are views each schematically showing the configuration of the holding member or chuck applicable to the bonding apparatus according to the embodiment;
Fig. 7 is a view schematically showing the configuration of a holding member; and
Fig. 8 is a flowchart for explaining a bonding method.

### DESCRIPTION OF THE EMBODIMENTS

Hereinafter, embodiments will be described in detail with reference to the attached drawings. Note, the following embodiments are not intended to limit the scope of the claims. Multiple features are described in the embodiments, but it is not the case that all such features are required, and multiple such features may be combined as appropriate. Each of the embodiments of the present invention described below can be implemented solely or as a combination of a plurality of the embodiments or features thereof where necessary or where the combination of elements or features from individual embodiments in a single embodiment is beneficial. Furthermore, in the attached drawings, the same reference numerals are given to the same or similar configurations, and redundant description thereof is omitted.

In the following description and accompanying drawings, directions will be described in accordance with an XYZ coordinate system. The Z-axis direction in the XYZ coordinate system may be parallel to a vertical direction, and an X-Y plane may be parallel to a horizontal plane, but the present disclosure is not necessarily limited thereto.

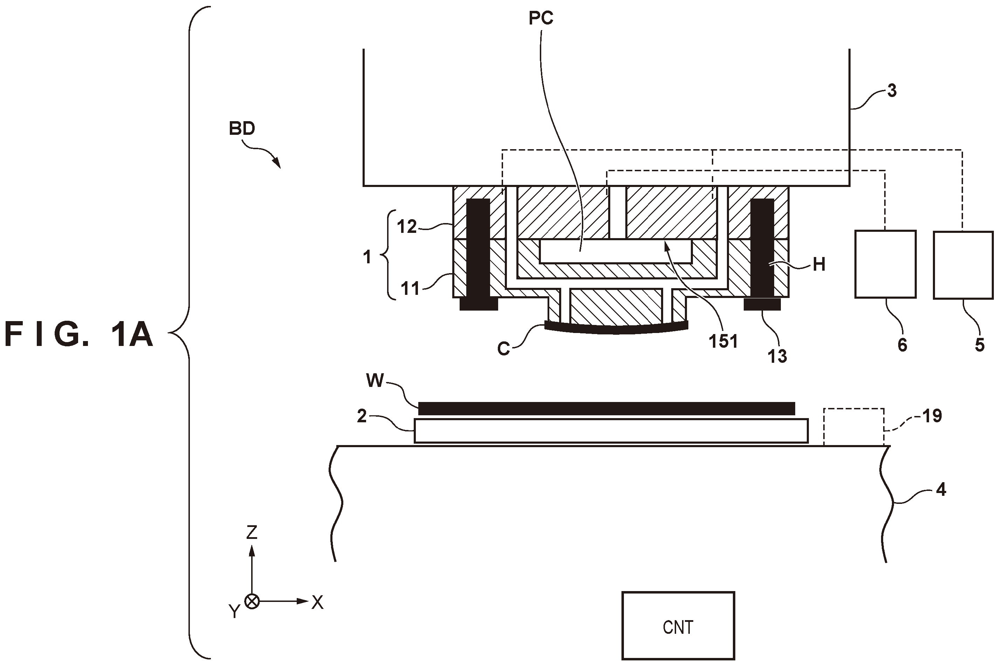

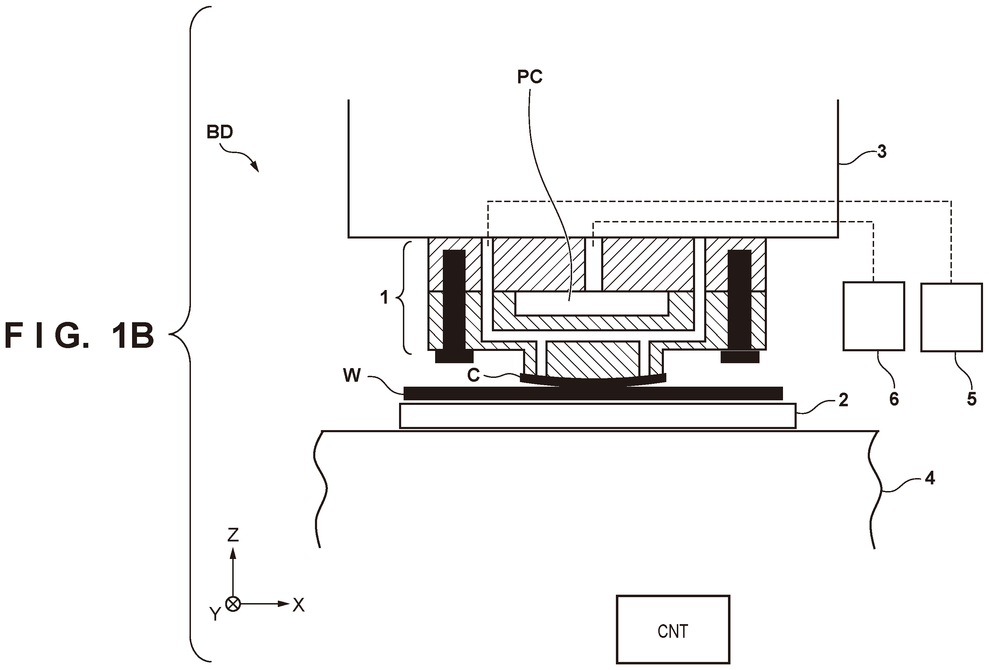

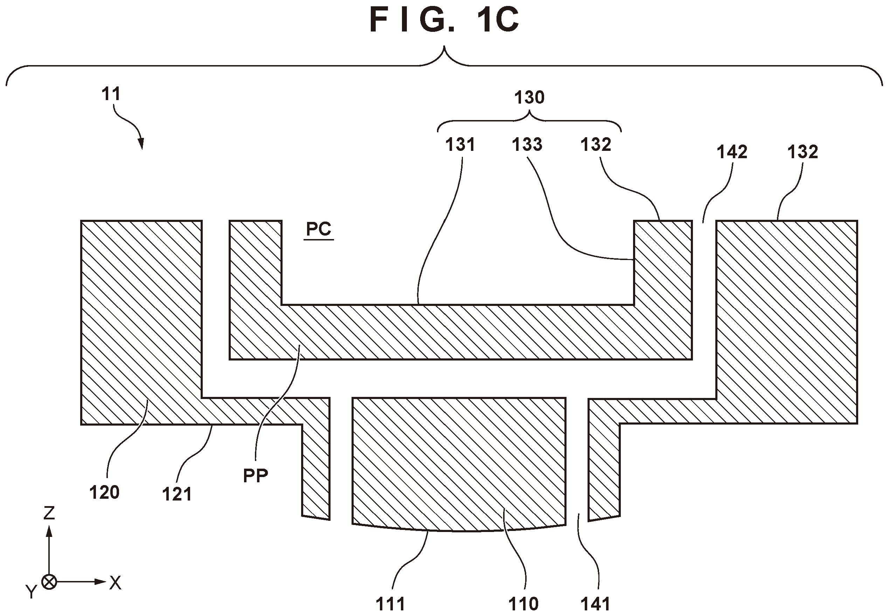

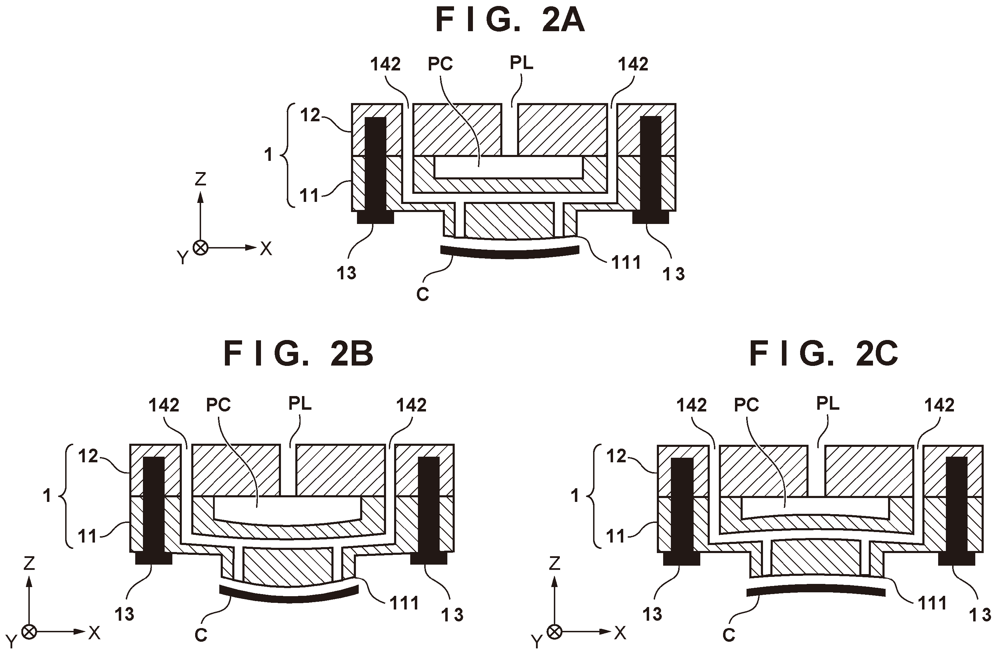

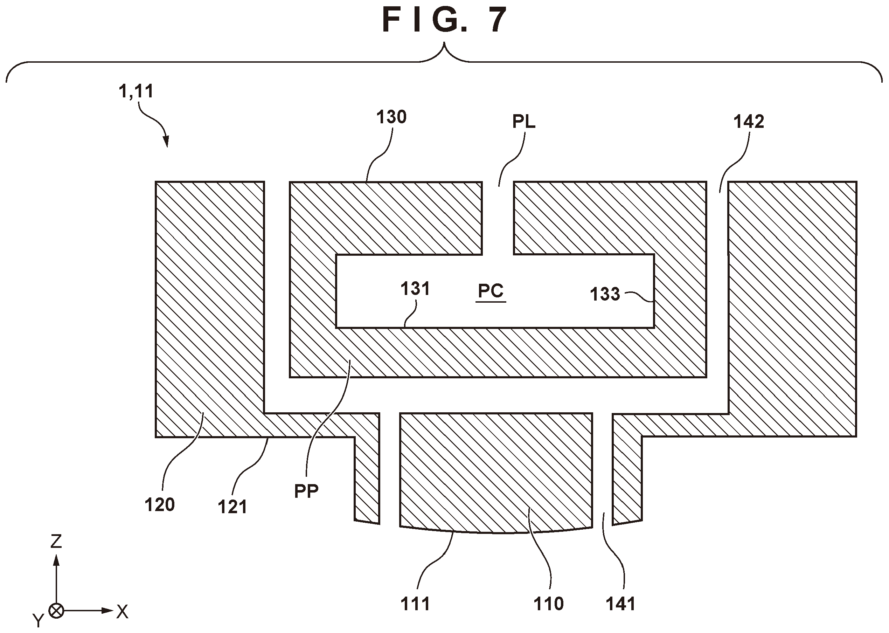

Figs. 1A and 1B schematically show a configuration example and operation example of a bonding apparatus BD according to an embodiment. Fig. 1C schematically shows a configuration example of a holder 11 (which may be understood as a holding member) applicable to the bonding apparatus BD. In Figs. 1A to 1C and in Figs. 2A to 2C and 7 to be referred to later, a shaded portion schematically represents a section. The bonding apparatus BD is configured to bond a first member C and a second member W. The first member C may be, for example, a diced chip (for example, a semiconductor chip). The second member W may be, for example, a wafer. The operation of the bonding apparatus BD is controlled by a controller CNT. The controller CNT includes, for example, a processor such as a CPU, and a memory or memory medium non-transitorily storing a program, and the operation of the bonding apparatus BD can be controlled by the processor executing the program.

The bonding apparatus BD can include a chuck 1 that includes the first holder 11 for holding the first member C, a head 3 that drives the chuck 1, and a shape controller 6 that controls the shape of the first member C by controlling the shape of a holding surface 111 of the first holder 11. The bonding apparatus BD can also include a second holder 2 that holds the second member W, and a stage driving mechanism (not shown) that drives the second member W by driving a stage 4 on which the second holder 2 is mounted. The second holder 2 can hold the second member W by, for example, a vacuum suction force, an electrostatic attraction force, a magnetic attraction force, or a mechanical force.

The first member C is held by the first holder 11 (holding member). From another viewpoint, the first member C is held by the chuck 1. In an example, the chuck 1 can include the first holder 11 and an adapter 12. The first holder 11 may be coupled (for example, adhered or bonded) to the adapter 12 so as not to be easily separated, or may be fixed so as to be easily separated. The chuck 1 can be fixed to the head 3 that drives the first member C. From another viewpoint, the adapter 12 can be fixed to the head 3. The head 3 can lift and lower the chuck 1 and the first member C by an elevating mechanism (not shown). The second member W is held by the second holder 2.

The first holder 11 or the chuck 1 can hold the first member C by a vacuum suction force. The vacuum suction force is a force for sucking a suction target by applying, to one surface of the suction target whose other surface is exposed to an environmental pressure such as the atmospheric pressure, a negative pressure (a pressure lower than the environmental pressure). The negative pressure is supplied from a vacuum source 5 (negative pressure supply source). The first holder 11 or the chuck 1 may hold the first member C by another method such as, for example, an electrostatic attraction force, a magnetic attraction force, or a mechanical clamp.

The first holder 11 can include a pressure-receiving surface 131 that defines at least a part of a pressure chamber PC. The first holder 11 can also include the holding surface 111 for holding the first member C. The shape controller 6 can control the shape of the holding surface 111 by controlling the pressure applied to the pressure-receiving surface 131. The shape controller 6 can control the shape of the first member C by controlling the shape of the holding surface 111. The area of the pressure-receiving surface 131 may be larger than the area of the first member C. The areas of the pressure-receiving surface 131 and the first member C can be the areas of the pressure-receiving surface 131 and the first member C in an orthogonal projection to the X-Y plane (horizontal plane), in other words, in a planar view or a plan view. From another viewpoint, the areas of the pressure-receiving surface 131 and the first member C can be the areas of the pressure-receiving surface 131 and the first member C in an orthogonal projection to a virtual plane orthogonal to the driving direction (elevating direction) of the first member C by the head 3. From still another viewpoint, the areas of the pressure-receiving surface 131 and the first member C can be the areas of the pressure-receiving surface 131 and the first member C in an orthogonal projection to the holding surface (the surface for holding the second member W) of the second holder 2.

The shape controller 6 can be configured to be capable of applying a negative pressure to the pressure-receiving surface 131 or the pressure chamber PC. The shape controller 6 can also be configured to be capable of applying the environmental pressure (for example, the atmospheric pressure) to the pressure-receiving surface 131 or the pressure chamber PC. The shape controller 6 can also be configured to be capable of applying a positive pressure to the pressure-receiving surface 131 or the pressure chamber PC. The environmental pressure is the pressure in a space where the bonding apparatus BD is arranged. From another viewpoint, the environmental pressure is the pressure in a space between the first member C and the second member W. The negative pressure is a pressure lower than the environmental pressure, and the positive pressure is a pressure higher than the environmental pressure. The pressure chamber PC may be filled with a fluid, and the shape controller 6 may control the pressure applied to the pressure-receiving surface 131 or the pressure chamber PC by controlling the pressure of the fluid. The fluid may be a gas such as air, or may be a liquid such as water or oil.

When bonding the first member C and the second member W, a stage driving mechanism (not shown) can first position the second holder 2 so that the first member C faces the bonding target position (region) on the second member W. Instead, a head driving mechanism (not shown) may position the head 3 (first member C) so that the first member C faces the bonding target position on the second member W. Alternatively, both the second member W and the first member C may be driven so that the first member C faces the bonding target position on the second member W. Then, as illustrated in Fig. 1B, the head 3 can lower the first member C to bring the first member C into contact with the bonding target position on the second member W. The contact between the first member C and the second member W can be started in the central portion of the first member C, and then the contact region therebetween can be expanded toward the periphery portion. This can be achieved by starting the contact between the first member C and the second member W in a state in which the shape controller 6 controls the shape of the first member C so that the first member C has a convex shape toward the second member W. The bonding is completed when the entire bonding surface of the first member C is in contact with the second member W. After the bonding is completed, the head 3 can release the holding of the first member C by the first holder 11 or the chuck 1, and lift the first holder 11 or the chuck 1. Instead of lifting and lowering the first holder 11 or the chuck 1, the second holder 2 may be lifted and lowered. Alternatively, the first holder 11 or the chuck 1 may be lifted and lowered and the second holder 2 may be lifted and lowered.

The first holder 11 includes a back surface 130 on the opposite side of the holding surface 111. The pressure-receiving surface 131 can be a part of the back surface 130. The back surface 130 can include a frame-shaped surface 132 contacting the adapter 12, and an inner surface 133 connecting the frame-shaped surface 132 and the pressure-receiving surface 131 and surrounding the side of the pressure chamber PC. The adapter 12 can include a surface 151 that faces the pressure-receiving surface 131 and forms a part of the pressure chamber PC. A vacuum sucker 141 (for example, a suction groove or a suction hole) can be provided in the holding surface 111, and a vacuum suction path 142 extending from the vacuum sucker 141 to the frame-shaped surface 132 can be provided in the first holder 11. The vacuum suction path 142 can be connected to the vacuum source 5. A valve is provided to the vacuum source 5 or between the vacuum source 5 and the vacuum suction path 142. The controller CNT functions as a holding controller that controls, by controlling the valve, the provision of the negative pressure from the vacuum source 5 to the vacuum suction path 142, that is, the holding of the first member C by the first holder 11.

The first holder 11 can include a mesa portion 110 including the holding surface 111, and a peripheral portion 120 which surrounds the mesa portion 110 and includes a facing surface 121 that faces the second holder 2. The first holder 11 can include a portion PP arranged between the facing surface 121 and the pressure-receiving surface 131. The first holder 11 can be replaceably attached to the adapter 12 using a fixing member 13 (for example, bolts, a magnet, an adhesive agent, or the like). From another viewpoint, the head 3 and the adapter 12 constitute a head structure, and the first holder 11 can be replaceably attached to the head structure using the fixing member 13. A plurality of holes H for fixing the first holder 11 to the adapter 12 or the head structure can be provided in the peripheral portion 120 of the first holder 11.

The holding surface 111 can have a convex shape when the pressure in the pressure chamber PC is at the environmental pressure such as the atmospheric pressure. In this case, since the convex shape can be obtained without necessarily applying the positive pressure to the pressure chamber PC, the configuration of the shape controller 6 can be simplified. The convex shape can be, for example, a spherical shape (a partial shape of a sphere). Note that the sphere here is one that is allowed to deviate from a mathematical sphere, and the allowed deviation can be 10% or less in the radius from the center of the mathematical sphere. The convex shape may be a dome shape. The term "dome shape" includes a spherical shape (a partial shape of a sphere). The holding surface 111 can approach a flat surface in accordance with the decompression of the pressure chamber PC. Alternatively, the holding surface 111 can become a concave surface after becoming a flat surface in accordance with the decompression of the pressure chamber PC.

Figs. 2A to 2C illustrate changes of the shape of the holding surface 111 of the first holder 11. When the pressure chamber PC is at the environmental pressure, the holding surface 111 of the first holder 11 can have a (downward) convex shape as shown in Fig. 2A. When the vacuum source 5 decompresses the vacuum suction path 142, the first member C is attracted to the holding surface 111 of the first holder 11, so that the first member C can be held by the first holder 11 in a curved state. Note that, in order to show the shape of the holding surface 111, a gap is provided between the holding surface 111 and the first member C in Figs. 2A to 2C. However, in practice, the first member C is held by the first holder 11 in a state in which the first member C is in contact with the holding surface 111.

A pressure path PL for connecting the pressure chamber PC and the shape controller 6 can be provided in the adapter 12. When the pressure chamber PC is set at the positive pressure by the shape controller 6, the curvature amount of the holding surface 111 can increase as shown in Fig. 2B. When the pressure chamber PC is set at the negative pressure by the shape controller 6, the shape of the holding surface 111 can change to a (downward) concave shape as shown in Fig. 2C. Alternatively, when the pressure chamber PC is set at the negative pressure by the shape controller 6, the shape of the holding surface 111 can be planarized. As described above, the shape of the holding surface 111 can change to a shape corresponding to the pressure in the pressure chamber PC.

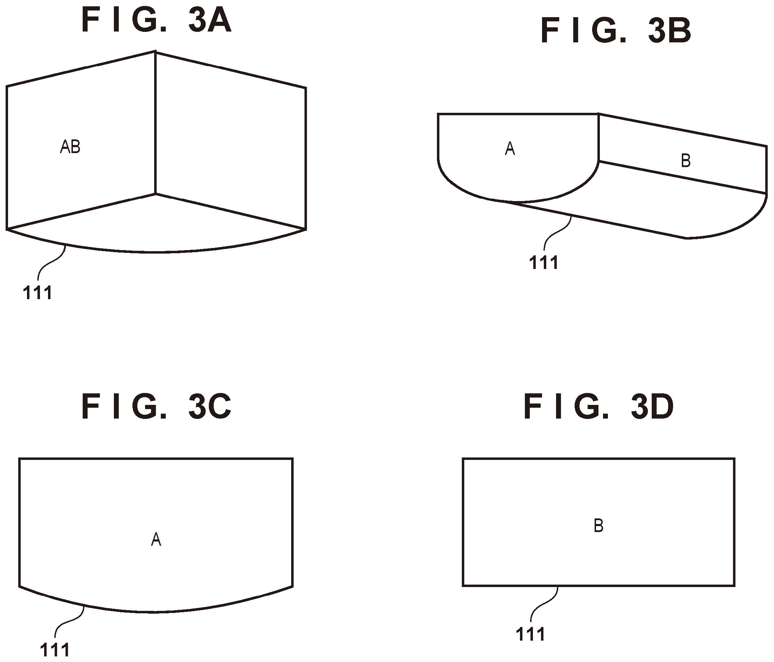

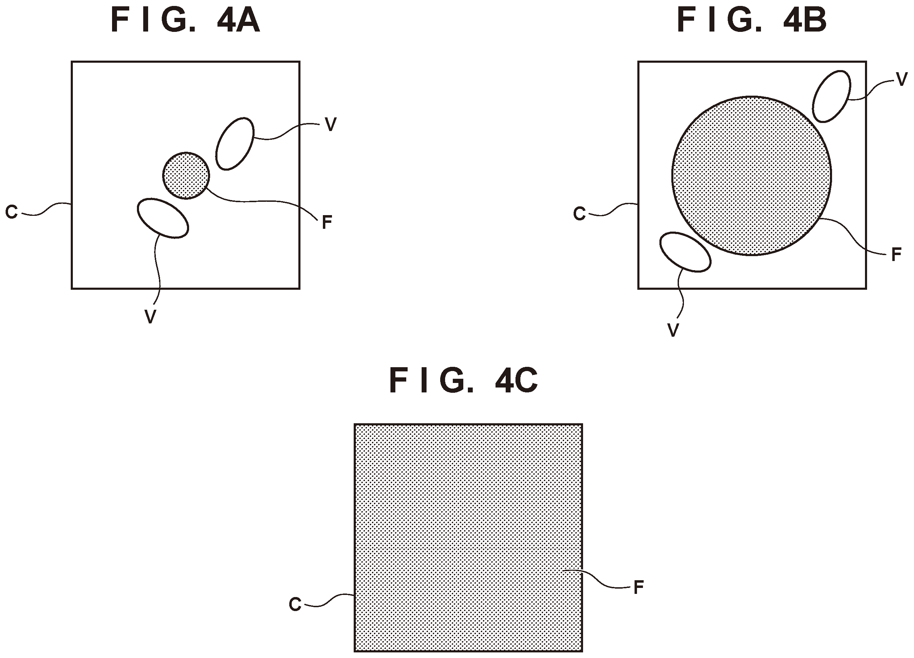

A configuration example of the first holder 11 will be described below with reference to Figs. 3A to 6C. As schematically shown as a perspective view in Fig. 3A, the holding surface 111 of the holder 11 can have a convex shape when the pressure chamber PC is at the environmental pressure. The convex shape can be a spherical shape or a dome shape. When the holding surface 111 has the convex shape, the first member C held by the holding surface 111 also has a convex shape, and the contact of the first member C with the second member W can be started from the central portion of the first member C. The convex shape is preferably the spherical shape or the dome shape as described above. By expanding a contact region (a region where the first member C contacts the second member W) F from the central portion of the first member C in the order of Fig. 4A to Fig. 4C, it is possible to effectively expel voids V from the central portion toward the peripheral portion while increasing the bonding speed.

Here, as illustrated in Figs. 3B to 3D, the holding surface 111 of the first holder 11 may have a shape that has a convex shape in a section parallel to a side surface A but does not have a convex shape in a section parallel to a side surface B. That is, the holding surface 111 may be, for example, a cylindrical surface. However, the configuration having a convex shape such as a spherical shape or a dome shape as illustrated in Fig. 3A is advantageous in terms of increasing the bonding speed and expelling the voids V.

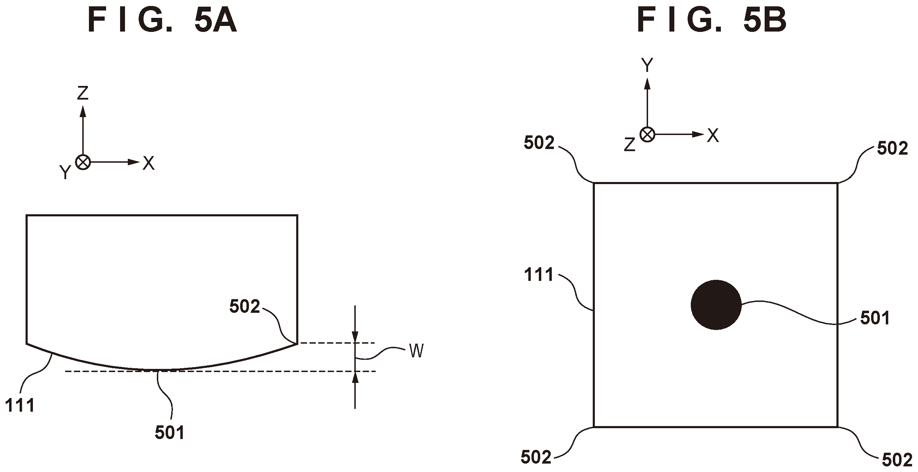

The surface roughness of the holding surface 111 with the envelope surface of the holding surface 111 as a reference may be allowed in accordance with the required precision. The maximum allowable local deviation amount of the holding surface 111 from the envelope surface can be, for example, 10 µm, 20µm, or 30 µm. Here, as shown in Fig. 5A, the maximum height difference of the holding surface 111 in a state in which the environmental pressure is provided to the pressure-receiving surface 131 (pressure chamber PC), that is, in a state in which the pressure applied to the holding surface 111 is equal to the pressure applied to the pressure-receiving surface 131, is defined as an initial curvature amount W. The maximum allowable amount is preferably sufficiently smaller than the initial curvature amount W. This ensures that the holding surface 111 has a convex shape regardless of the processing accuracy of the individual holding surface 111.

The initial curvature amount W can be decided based on, for example, at least one of the dimension and area of the holding surface 111. Alternatively, the initial curvature amount W can be decided based on at least one of the dimension, area, and thickness of the first member C held by the holding surface 111. Alternatively, the initial shape as the shape of the holding surface 111 in a state in which the environmental pressure is provided to the pressure-receiving surface 131 (pressure chamber PC) can be decided based on at least one of the dimension, area, and thickness of the first member C held by the holding surface 111.

In a case where the holding surface 111 is formed by a spherical surface (a part thereof) and the initial shape of the holding surface 111 is decided with respect to a given first member C, at least one of the initial curvature amount W and the sphere radius can be optimized. The initial curvature amount W can be decided within a range of, for example 5 µm to 400 µm. Alternatively, the initial curvature amount W can be decided within a range of 5 µm to 50 µm or a range of 50 µm to 100 µm. Alternatively, the initial curvature amount W can be decided within a range of 100 µm to 200 µm, a range of 200 µm to 300 µm, a range of 300 µm to 400 µm, or a range of 400 µm to 500 µm. In an example, for the first member C having a dimension of 10 mm × 10 mm, the initial curvature amount W can be decided within a range of 5 µm to 15 µm, for example, set to 10 µm. Assuming the first members C having various specifications, various kinds of the first holders 11 are preferably prepared.

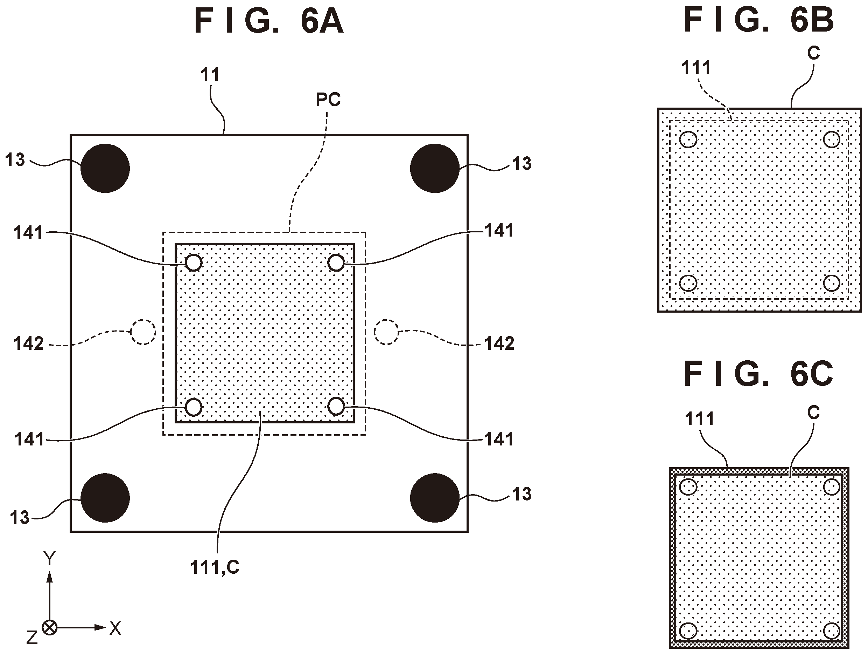

Fig. 6A illustrates a planar view of the first holder 11. In the example shown in Fig. 6A, four fixing members 13 are used to fix the first holder 11 to the adapter 12. Each fixing member 13 can be arranged in a corner portion of the first holder 11. However, the number and positions of the fixing members 13 can be changed. The area of the pressure chamber PC may be larger than the area of the first member C. From another viewpoint, the dimension of the pressure chamber PC in the Y-axis direction may be larger than the dimension of the first member C in the X-axis direction, and the dimension of the pressure chamber PC in the Y-axis direction may be larger than the dimension of the first member C in the Y-axis direction. From still another viewpoint, in a planar view, the outer edge of the first member C can fit inside the outer edge of the pressure chamber PC. In the example shown in Fig. 6A, the area of the holding surface 111 can be equal to the area of the first member C.

Fig. 6B shows an example in which the area of the holding surface 111 is smaller than the area of the first member C. This configuration can reduce a possibility of scratching the holding surface 111 when holding the first member C by the holding surface 111 and/or a possibility of chipping the corner portion of the first member C when holding the first member C by the holding surface 111 so as to curve the first member C. Fig. 6C shows an example in which the area of the holding surface 111 is larger than the area of the first member C. This configuration is advantageous for curving the entire region of the first member C when holding the first member C by the holding surface 111.

Fig. 7 schematically shows another embodiment of a holder 11 (which may be understood as a holding member) applicable to a bonding apparatus BD. As schematically shown in Fig. 7, in the other embodiment, the first holder 11 includes a back surface 130 on the opposite side of a holding surface 111, and a pressure chamber PC is arranged between the holding surface 111 and the back surface 130. In this case, an adapter 12 may not be provided, and the first holder 11 can constitute a chuck 1. The first holder 11 can be fixed to a head 3 using a fixing member (not shown). The first holder 11 or the chuck 1 according to the other embodiment can be formed by, for example, a 3D printer.

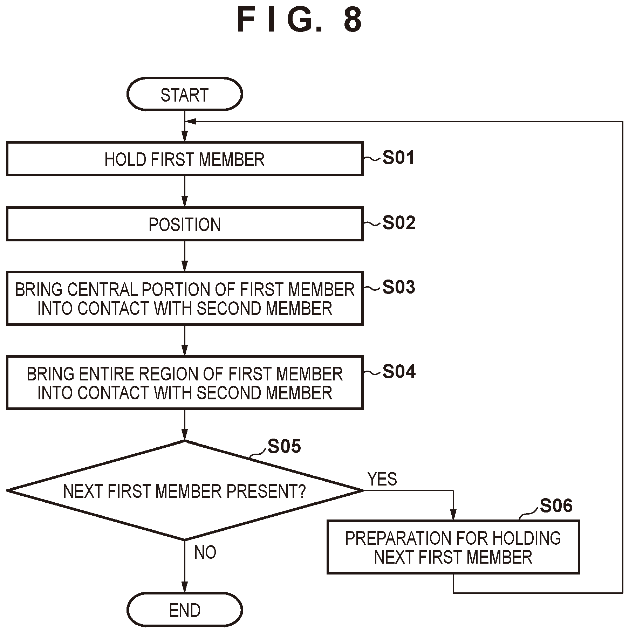

Fig. 8 exemplarily describes the operation method (bonding method) of the bonding apparatus BD. The operation of the bonding apparatus BD exemplarily described in Fig. 8 is controlled by the controller CNT. In step S01, the first member C is held by the first holder 11. At this time, the shape controller 6 provides the environmental pressure to the pressure chamber PC of the first holder 11, so that the holding surface 111 of the first holder 11 can have a curvature (convex shape) with the initial curvature amount W. Alternatively, the shape controller 6 provides a negative pressure to the pressure chamber PC of the first holder 11, so that the holding surface 111 of the first holder 11 can have a shape with a curvature smaller than the initial curvature amount W, or a flat shape.

In step S02, a stage driving mechanism (not shown) can position the stage 4 holding the second holder 2 so that the first member C faces the bonding target position (region) on the second member W. Instead, a head driving mechanism (not shown) may position the head 3 (first member C) so that the first member C faces the bonding target position on the second member W. Alternatively, both the second member W and the first member C may be driven so that the first member C faces the bonding target position on the second member W. At this time, the environmental pressure may be applied to the pressure chamber PC of the first holder 11 to cause the holding surface 111 to hold the first member C curved with the first curvature amount, or the negative pressure may be applied to the pressure chamber PC to hold the first member C in a flat or nearly flat shape.

In step S03, at least one of the first holder 11 and the second holder 2 can be driven to bring the central portion of the first member C into contact with the bonding target position on the second member W. At this time, the shape controller 6 may provide positive pressure to the pressure chamber PC to make the curvature amount of the first member C larger than the initial curvature amount, or may provide the environmental pressure. When the shape controller 6 provides the positive pressure to the pressure chamber PC to make the curvature amount of the first member C larger than the initial curvature amount, in order to prevent damage to the first member C, the curvature amount of the first member C can be set equal to or smaller than three times the initial curvature amount W. In other words, the maximum curvature amount applied to the first member C by the shape controller 6 can be set equal to or smaller than three times the curvature amount (initial curvature amount W) of the first member C at the time when the pressure chamber PC is at the environmental pressure.

In step S04, at least one of the first holder 11 and the second holder 2 can be driven to bring the entire region of the first member C into contact with the bonding target position on the second member W. At this time, the shape controller 6 may provide the pressure chamber PC with the positive pressure, the environmental pressure, or the negative pressure. The shape of the holding surface 111 can change in accordance with the pressure in the pressure chamber PC.

In step S05, the controller CNT checks whether there is the first member C to be bonded next. If there is the first member C to be bonded next, the process advances to step S06. If there is no first member C to be bonded next, the operation shown in Fig. 8 is terminated.

In step S06, at least one of the head 3 and the stage 4 can be driven to the position for holding the first member C to be bonded next. Note that a mechanism for providing multiple first members C may be arranged on the stage 4. In this case, the shape controller 6 provides the environmental pressure to the pressure chamber PC of the first holder 11, so that the holding surface 111 of the first holder 11 can have a curvature (convex shape) with the initial curvature amount W. Alternatively, the shape controller 6 provides a negative pressure to the pressure chamber PC of the first holder 11, so that the holding surface 111 of the first holder 11 can have a shape with a curvature smaller than the initial curvature amount W, or a flat shape.

The bonding apparatus BD may include a detector 19 that can detect the contact timing when the first member C comes into contact with the second member W. The controller CNT can control the shape controller 6 in accordance with the detection by the detector 19 to adjust the curvature amount of the holding surface 111 (first member C) of the first holder 11 in accordance with the contact timing. Alternatively, the controller CNT may control the shape controller 6 in accordance with the detection by the detector 19 to adjust the shape of the holding surface 111 (first member C) in accordance with the expansion of the contact region between the first member C and the second member W. The contact timing may be detected using, for example, a method of observing the contact between the first member C and the second member W by a camera. Alternatively, the contact timing may be detected using a method of detecting the distance between the first holder 11 (or a member moving together with the first holder 11) and the second holder 2 using a displacement sensor such as a laser displacement gauge. Alternatively, the contact timing may be detected by detecting the change of a load applied to the first holder 11 or the second holder 2, which occurs when the first member C and the second member W contact each other, using a touch sensor. The detection function may be used to adjust the curvature amount of the holding surface 111 (and the first member C) in step S03 and step S04 of Fig. 8.

An article manufacturing method according to an embodiment can include a step of forming a bonded object of a first member C and a second member W by bonding the first member C and the second member W by a bonding apparatus BD, and a processing step of processing the bonded object to obtain an article. The first member C can be, for example, a chip such as a semiconductor chip. The second member W can be, for example, a wafer such as a semiconductor substrate. The bonded object can be, for example, a semiconductor device.

Various embodiments have been described in detail above but it will be understood that the present disclosure is not limited to these embodiments and encompasses all modifications, variants, alternatives and equivalents falling within the scope of the appended claims.

## Claims

1. A bonding apparatus (BD) that bonds a first member (C) and a second member (W), the apparatus (BD) comprising:
a first holder (11) including a pressure-receiving surface (131) which defines at least a part of a pressure chamber (PC), and a holding surface (111) which holds the first member (C);
a second holder (2) configured to hold the second member (W); and
a shape controller (6) configured to control a shape of the holding surface (111) by controlling a pressure applied to the pressure-receiving surface (131),
wherein an area of the pressure-receiving surface (131) is larger than an area of the first member (C).

2. The apparatus (BD) according to claim 1, wherein
the first holder (11) includes a back surface (130) on an opposite side of the holding surface (111), and the pressure-receiving surface (131) is a part of the back surface.

3. The apparatus (BD) according to claim 2, further comprising:
a head (3) configured to drive the first member (C); and
an adapter (12) fixed to the head (3),
wherein the back surface (130) further includes a frame-shaped surface (132) contacting the adapter (12), and an inner surface (133) connecting the frame-shaped surface (132) and the pressure-receiving surface (131) and surrounding a side of the pressure chamber (PC).

4. The apparatus (BD) according to claim 3, wherein
the adapter (12) includes a surface facing the pressure-receiving surface (131) and forming a part of the pressure chamber (PC).

5. The apparatus (BD) according to claim 3, wherein
a vacuum sucker (141) is provided in the holding surface (111), and
a vacuum suction path (142) extending from the vacuum sucker (141) to the frame-shaped surface (132) is provided in the first holder (11).

6. The apparatus (BD) according to claim 3, wherein
the first holder (11) includes a mesa portion (110) including the holding surface (111), and a peripheral portion (120) including a facing surface (121) which surrounds the mesa portion (110) and faces the second holder (2), and
the first holder (11) includes a portion (PP) arranged between the facing surface (121) and the pressure-receiving surface (131).

7. The apparatus (BD) according to claim 3, wherein
the first holder (11) is attached to the adapter using a fixing member (13).

8. The apparatus (BD) according to claim 6, wherein
a plurality of holes (H) used to fix the first holder (11) to the adapter (12) are provided in the peripheral portion (120).

9. The apparatus (BD) according to claim 1, wherein
the first holder (11) includes a back surface (130) on an opposite side of the holding surface (111), and the pressure chamber (PC) is arranged between the holding surface (111) and the back surface (130).

10. The apparatus (BD) according to claim 1, wherein
the holding surface (111) has a convex shape when a pressure in the pressure chamber (PC) is at an environmental pressure.

11. The apparatus (BD) according to claim 10, wherein
the convex shape is a spherical shape.

12. The apparatus (BD) according to claim 10, wherein
the holding surface (111) approaches a flat surface in accordance with decompression of the pressure chamber (PC).

13. The apparatus (BD) according to claim 10, wherein
the holding surface (111) becomes a concave surface after becoming a flat surface in accordance with decompression of the pressure chamber (PC).

14. The apparatus (BD) according to claim 1, wherein
the shape controller (6) is configured to be capable of applying a negative pressure to the pressure-receiving surface (131).

15. The apparatus (BD) according to claim 1, further comprising a detector (19) configured to detect a contact between the first member (C) and the second member (W),
wherein the shape controller (6) is controlled in accordance with detection by the detector (19).

16. The apparatus (BD) according to claim 1, wherein
a maximum curvature amount applied to the first member (C) by the shape controller (6) is not more than three times a curvature amount of the first member (C) at the time when the pressure chamber (PC) is at an environmental pressure.

17. A holding member (11) that holds a member (C), wherein
the holding member (11) includes a pressure-receiving surface (131) which defines at least a part of a pressure chamber (PC), and a holding surface (111) which holds the member (C), and
an area of the pressure-receiving surface (131) is larger than an area of the member (C).

18. An article manufacturing method comprising:
forming a bonded object of a first member (C) and a second member (W) by bonding the first member (C) and the second member (W) by a bonding apparatus (BD) defined in any one of claims 1 to 16; and
processing the bonded object to obtain an article.
